# EUROPÄISCHE PATENTSCHRIFT

(11) **EP 3 939 159 B1**
(45) Veröffentlichungstag und Bekanntmachung des Hinweises auf die Patenterteilung: **28.06.2023**
(21) Anmeldenummer: 20711880.3
(22) Anmeldetag: 13.03.2020
(51) Int. Cl.: H02S 30/20, H02S 20/30, H01L 31/02

(54) **VORRICHTUNG ZUR ENERGIEERZEUGUNG, INSBESONDERE SOLARANLAGE**
APPARATUS FOR GENERATING ENERGY, IN PARTICULAR SOLAR INSTALLATION
DISPOSITIF POUR LA PRODUCTION D'ÉNERGIE, EN PARTICULIER UNE INSTALLATION SOLAIRE

(30) Priorität: 14.03.2019 DE 102019106513
(43) Veröffentlichungstag der Anmeldung: 19.01.2022
(73) Patentinhaber: Klaus Faber AG, 66113 Saarbrücken (DE)
(72) Erfinder: HÖRSTENSMEYER, Frank, 50858 Köln (DE); BINZ, Fabian, 76571 Gaggenau (DE); LERICH, Andreas, 76448 Durmersheim (DE); WUTSCHI, Rolf, 76571 Gaggenau (DE)
(74) Vertreter: Zeiner, Johannes Michael
(86) Internationale Anmeldenummer: PCT/EP2020/056915
(87) Internationale Veröffentlichungsnummer: WO 2020/183001

(56) Entgegenhaltungen:
- EP-A1- 2 822 178
- US-A1- 2004 124 711
- US-A1- 2013 186 450
- US-A1- 2018 287 549

## Beschreibung

Die Erfindung betrifft eine Vorrichtung zur Energieerzeugung, insbesondere eine Solaranlage, die ein Schutzgehäuse und eine Einrichtung zum Halten von Energieerzeugungselementen aufweist, die Halteeinrichtung, die einen mehrteiligen Halterahmen umfasst, aus einer Schutzstellung, in der die Energieerzeugungselemente in dem Schutzgehäuse angeordnet sind, in eine Energieerzeugungsstellung, in der die Energieerzeugungselemente außerhalb des Schutzgehäuses angeordnet sind, bewegbar ist.

US 2013/0186450 A1 beschreibt einen Solarcontainer 100, in dem in einer Schutzstellung einen Stoß bildende Energieerzeugungselemente 124, die an einem mehrteiligen Halterahmen 104 ("solar arm") mit mehreren Halterahmenteilen 122 angebracht sind, in dem Container angeordnet sind. Zur Bewegung in eine Energieerzeugungsstellung werden die Halterahmenteile 122 auf Schienen 126, an die Rollen 127 der Halterahmenteile 122 anliegen, durch eine Linearbewegung in Schienenlängsrichtung aus dem Solarcontainer 100 herausgezogen, wodurch der Stoß gelenkig miteinander verbundener Halterahmenteile 122 aufgelöst wird.

Aus US 2018/0287549 A1 ist ein Solarcontainer 102 bekannt, auf dessen Außenseiten zwischen Eckpfeilern ("protruding frame") und einer Außenwand Ausnehmungen 106 gebildet sind, in denen Solarmodule 104 an einem Halterahmen angeordnet sind, der zur Bewegung in eine Energieerzeugungsstellung aus den Ausnehmungen 102 heraus verschwenkbar ist. Dadurch, dass die Solarmodule 104 ungeschützt an der Außenseite angebracht sind, sind sie außerdem nicht aus einer Schutzstellung, in der sie in dem Container angeordnet sind, in eine Energieerzeugungsstellung verschwenkbar, sondern permanent in einer "Schutzlosstellung".

US 2004/0124711 A1 beschreibt einen Solarcontainer 10, in dessen Innenraum Solarmodule 18 sowie eine Halteeinrichtung 14,20 für die Solarmodule transportiert werden können und an einem Ort, an dem der Solarcontainer 10 eingesetzt wird, auf der Außenseite befestigt werden. Bei weiter Auslegung von Anspruch 1 könnte eine Transportlagerung in dem Innenraum eine Schutzstellung und ein Herausnehmen sowie eine Montage der Einzelteile an dem Container eine Bewegung in die Energieerzeugungsstellung sein.

Aus EP 2 822 178 A1 ist eine einen Container 3 aufweisende Solaranlage 1 bekannt, aus dem ein Solarmodule, als Auszug bezeichnetes tragendes Haltegestell 10 herausziehbar ist, wobei das Haltegestell mehrere Haltegestellteile aufweist, die verschwenkbar miteinander verbunden sind.

Aus dem Stand der Technik sind außerdem mit einem Lastkraftwagen transportierbare sogenannte Solarcontainer bekannt, die zum Einsatz an schlecht zugänglichen Orten ohne Energie-versorgungsinfrastruktur vorgesehen sind, insbesondere in Krisengebieten. In bekannte Solarcontainer sind Solarmodule eingebracht, die an einem Einsatzort aus dem Container entnommen und daran oder darauf befestigt werden und elektrischen Strom erzeugen. Nachteilig ist der komplizierte Aufbau, der besondere Fachkenntnisse und zum Teil Spezialwerkzeuge erfordert.

Der vorliegenden Erfindung liegt die Aufgabe zugrunde, eine Vorrichtung der eingangs genannten Art zu schaffen, die besonders einfach bedienbar ist.

Erfindungsgemäß wird die Aufgabe dadurch gelöst, dass der Halterahmen zur Bewegung aus der Schutzstellung in die Energieerzeugungsstellung aus dem Schutzgehäuse heraus um eine vertikale Achse verschwenkbar ist.

Dadurch, dass die Halteeinrichtung bewegbar ist, ist eine manuelle Entnahme der Energieerzeugungselemente, die vorzugsweise als Solarmodule ausgebildet sind, aus dem Schutzgehäuse und deren Montage an oder auf dem Container nicht mehr erforderlich. Eine vorzugsweise geführte Bewegung aus der Schutzstellung in die Energieerzeugungsstellung ist ausreichend, damit die Vorrichtung betriebsbereit ist. Eine Aufbauzeit ist stark verkürzt. Besondere Werkzeuge oder tiefgehende Montagekenntnisse sind vorteilhaft nicht erforderlich.

Zum Abbau und Weitertransport an einen anderen Einsatzort können die Energieerzeugungselemente zurück in die Schutzstellung bewegt werden.

Die Halteeinrichtung ist zur Bewegung aus der Schutzstellung in die Energieerzeugungsstellung aus dem Schutzgehäuse heraus um eine vertikale Achse verschwenkbar. Dazu können insbesondere Drehgelenke vorgesehen sein. Vorteilhaft ist eine besonders einfache Verschwenkbewegung, die durch eine einzige Person ohne Werkzeuge ausgeführt werden kann, aus dem Schutzgehäuse heraus möglich.

Ferner kann ein mehrteiliges Sicherungshalteelement vorgesehen sein, dessen Betätigung erforderlich ist, um eine Verschwenkbewegung freizugeben. Durch eine solche Sicherung wird vorteilhaft ein unerwünschtes Verschwenken des Halterahmens, insbesondere bei einem Transport per Lastkraftwagen oder Schiff, verhindert. Das Sicherungshalteelement kann beispielsweise an einem der Drehgelenke angebracht sein und dessen Drehbarkeit bis zu einer manuellen Freigabe blockieren.

Denkbar ist außerdem, dass ein erster zapfenförmiger Teil des Sicherungshalteelements an einer einem Drehgelenk abgewandten Seite des Halterahmens angebracht ist und eine Einrichtung zur lösbaren Fixierung des zapfenförmigen Teils auf einer Schutzgehäuseinnenseite. Dadurch wird der mindestens eine Halterahmen besonders ortsfest in der Schutzstellung gehalten.

In einer Ausgestaltung der Erfindung bilden Halterahmenteile des mehrteiligen Halterahmens in der Schutzstellung einen Stoß und sind insbesondere verschwenkbar miteinander verbunden. Ein zur Verfügung stehender Stauraum in dem Schutzgehäuse, in dem die Energieerzeugungselemente in der Schutzstellung verstaut sind, kann nahezu vollständig genutzt werden. Durch die verschwenkbare Verbindung benachbarter Halterahmenteile ist ein einfaches Auflösen des Stapels durch Verschwenken ohne Einsatz von Werkzeugen möglich. Vorteilhaft wird ein zur Verfügung stehender Stauraum besonders gut genutzt und gleichzeitig eine besonders einfache Handhabung bei der Bewegung aus der Schutzstellung heraus in die Energieerzeugungsstellung sichergestellt.

Die Halterahmenteile sind vorzugsweise aus Stahl und/oder einer Leichtmetalllegierung, die insbesondere Aluminium oder/und Magnesium aufweist, gebildet. Sind die Halterahmenteile rahmenartig ausgebildet, ist eine besonders hohe Steifigkeit möglich. Ferner können die Energieerzeugungselemente schützend von den Halterahmenteilen umgeben werden.

In einer weiteren Ausgestaltung der Erfindung ist zwischen benachbarten Halterahmenteilen des Halterahmens der Halteeinrichtung ein in seiner Länge veränderbares Abstützelement vorgesehen ist, das in der Energieerzeugungsstellung gegen einen Untergrund, auf dem das Schutzgehäuse steht, anliegt. Aufgrund des Eigengewichts der Energieerzeugungselemente sowie der Halterahmenteile ist eine Abstützung des Halterahmens erforderlich. Dadurch, dass das Abstützelement zwischen benachbarten Halterahmenteilen angeordnet ist, können vorteilhaft zwei Halterahmenteile mit einem einzige Element abgestützt werden.

Durch die Veränderbarkeit der Länge muss ein Untergrund, auf dem der Container steht, nicht eben sein. Unebenheiten können ausgeglichen werden.

In einer Ausgestaltung der Erfindung weist ein Halterahmenteil des Halterahmens der Halteeinrichtung mindestens ein mehrteiliges, vorzugsweise zweiteiliges, Energieerzeugungselement auf, dessen Energieerzeugungselementteile relativ zueinander bewegbar, insbesondere verschwenkbar sind, wobei die beiden Teile vorzugsweise in der Schutzstellung einen Stoß bilden, bei dem Energieerzeugungsseiten einander zugewandt sind. Bilden die mindestens zwei Teile einen Stoß, bei dem Energieerzeugungsseiten einander zugewandt sind, können diese vorteilhaft besonders gut geschützt werden. Insbesondere Solarmodule weisen empfindliche Energieerzeugungsseiten auf, bei deren Beschädigung oder Verschmutzung Leistungseinbußen auftreten.

Dadurch, dass sowohl Halterahmenteile eines mehrteiligen Halterahmens als auch die Energieerzeugungselemente in der Schutzstellung einen Stoß bilden, ist eine besonders kompakte Anordnung, durch die ein zur Verfügung stehender Stauraum besonders gut nutzbar ist, vorteilhaft möglich.

In einer weiteren Ausgestaltung der Erfindung weist ein Halterahmenteil eines Halterahmens der Halteeinrichtung mindestens ein mehrteiliges, vorzugsweise zweiteiliges, Energieerzeugungselement auf, dessen eines Energieerzeugungselementteil verschwenkbar mit dem Halterahmenteil verbunden ist. Vorteilhaft kann das Energieerzeugungselement in eine optimale, insbesondere einem Sonnenstand nachgeführte Energieerzeugungsstellung, in der die mindestens zwei Energieerzeugungselementteile der Sonne oder wenigstens dem Himmel zugewandt sind, verschwenkt werden.

In einer Ausgestaltung der Erfindung ist das Schutzgehäuse quaderförmig ausgebildet, vorzugsweise als Container, insbesondere als Frachtcontainer, besonders bevorzugt als 20- oder 40-Fuß-Container. Durch eine Ausbildung als standardisierter Frachtcontainer ist vorteilhaft sichergestellt, dass ein einfacher Transport per Schiff oder Lastkraftwagen erfolgen kann.

Zweckmäßigerweise weist das Schutzgehäuse mindestens zwei von außen zugängliche Räume auf, von denen ein erster zur Aufnahme der Energieerzeugungselemente in der Schutzstellung vorgesehen ist und ein zweiter zur Aufnahme elektrischer und/oder elektronischer Bauteile oder Baugruppen eingerichtet ist. Durch diese Aufteilung des Schutzgehäuses wird sichergestellt, dass eine erfindungsgemäße Vorrichtung sowohl zur Energieerzeugung als auch zu deren Nutzung oder Einspeisung von erzeugtem Strom in ein Stromnetz möglich ist. Dadurch, dass jeder der Räume von außen zugänglich sind, ist eine Wartung oder Reparatur einzelner Bauteile oder Baugruppen in dem Raum besonders einfach. Denkbar ist ferner, dass in den zweiten Raum mindestens ein Energiespeicher eingebracht ist, der beispielsweise eine oder mehrere Batterien umfassen kann. Vorteilhaft kann elektrische Energie bei Leistungsüberschüssen bei der Energieerzeugung, beispielsweise tagsüber, gespeichert und nachts genutzt werden.

In einer Ausgestaltung der Erfindung ist der zweite Raum zur Aufnahme mindestens eines Traggestells vorgesehen, an dem elektrische und/oder elektronische Bauteile oder Baugruppen angebracht sind und das insbesondere in den Raum einschiebbar ist. Das mindestens eine Traggestell kann regalartig als einzelnes Modul ausgebildet sein. Obwohl eine Verbindung des Traggestells mit dem Schutzgehäuse nicht erforderlich ist, ist das Traggestell vorzugsweise elektrisch und mechanisch lösbar mit dem Schutzgehäuse verbindbar. Eine mechanische Verbindung ist zur besonders stabilen Anordnung in dem Schutzgehäuse vorgesehen, während eine elektrische Verbindung zur An- und Verbindung der elektrischen oder elektronischen Bauteile oder Baugruppen untereinander und/oder mit den Energieerzeugungselementen vorgesehen ist. Beispielweise kann ein erstes Traggestell mit aufladbaren Batterien versehen sein und ein zweites mit einer zur solaren Energieerzeugung erforderlichen Leistungselektronik, beispielsweise Gleich- oder Wechselrichtern. Das Traggestell kann außerdem Aufnahmetaschen für Gabeln eines Gabelstaplers umfassen. Dadurch ist ein ein besonders einfacher Austausch und Einbau der Module in das Schutzgehäuse möglich.

In einer weiteren Ausgestaltung der Erfindung ist das Traggestell auf einer aus dem Schutzgehäuse herausziehbaren Trageinrichtung, die insbesondere Tragschienen umfasst, angeordnet, wobei die Tragschienen in einer Wartungsstellung des Traggestells gegen einen Endanschlag anliegen.

Die Tragschienen sind vorzugsweise als Führungsschienen ausgebildet, die eine geführte Bewegung in die Wartungsstellung ermöglichen, wobei die Wartungsstellung eine Stellung ist, in der das Traggestell aus dem Schutzgehäuse herausgeführt ist und daran angebrachte Komponenten vorteilhaft von mehreren Seiten zugänglich sind, beispielsweise für Reparaturarbeiten. Dadurch, dass ein Endanschlag vorgesehen ist, wird verhindert, dass das Traggestell über die Wartungsstellung heraus aus dem Schutzgehäuse entnommen wird. Eine erneutes Hineinschieben nach Abschluss der Wartungs- oder Reparaturarbeiten ist möglich.

In einer Ausgestaltung der Erfindung ist das Traggestell auf einer dem Schutzgehäuse zugewandten Seite mit einem elektrischen Verbindungsstecker versehen, der im eingeschobenen Zustand zum lösbaren Eingriff in eine in dem Schutzgehäuse angebrachte Verbindungsbuchse eingerichtet ist. Vorteilhaft wird eine elektrische Verbindung der an dem Traggestell angebrachten Bauteile untereinander oder insbesondere mit den Energieerzeugungselementen auf einfache Weise möglich ("plug&play").

Zweckmäßigerweise ist weiterer, von außen zugänglicher Raum vorgesehen, der zur Aufnahme eines batteriebetriebenen Erzeugnisses, insbesondere eines elektrisch angetriebenen Fahrzeugs, während eines Batterieladevorgangs eingerichtet ist. Eine Ausbildung als Garage für ein solches Fahrzeug, das ein Auto, ein Motorrad oder ein Fahrrad sein kann, ist denkbar. Das Schutzgehäuse ermöglicht nicht nur ein Aufladen einer Batterie, sondern schützt das Fahrzeug gleichzeitig vor unbefugten Zugriffen.

Außerdem ist denkbar, dass der weitere Raum frei zugänglich ist und einzelne, abschließbare Fächer aufweist, in denen Mobilgeräte wie Laptop-Computer, Mobiltelefone oder austauschbare Batterien gelagert und aufgeladen werden können.

In einer Ausgestaltung der Erfindung ist ein Schutzgehäuseseitenwandabschnitt als vorzugsweise mehrflügelige Tür ausgebildet ist, die sich von einer ersten Stirnseite des Schutzgehäuses bis zu einem zweiten Aufnahmeraum erstreckt. Durch die geöffnete Tür wird vorzugsweise ein Halterahmen einer Halteeinrichtung für Energieerzeugungselemente bei deren Bewegung aus der Schutz- in die Energieerzeugungsstellung hindurch bewegt. Durch die mehrflügelige Ausbildung können die Türflügel nach deren Öffnen stoßartig und damit besonders platzsparend angeordnet werden. Denkbar ist, dass jeder der Flügel an einer Ober- und einer Unterseite mit Führungselementen versehen ist, die zum Eingriff in eine an dem Schutzgehäuse angebrachte Führungseinrichtung, die eine Führungsschiene umfassen kann, eingerichtet ist. Sind die Führungselemente als Führungsrollen ausgebildet, ist ein Aufschieben der einzelnen Flügel mit geringem Kraftaufwand möglich.

Denkbar ist außerdem eine mehrflügelige Ausbildung der Tür, bei der benachbarte Flügel verschwenkbar miteinander verbunden sind. Vorteilhaft ist keine Führungseinrichtung erforderlich.

Zweckmäßigerweise ist ein Schutzgehäuseseitenwandabschnitt als vorzugsweise mehrflügelige Tür ausgebildet, die in der Schutzstellung und in der Energieerzeugungsstellung verschließbar ist. Vorteilhaft können ein unbefugtes Eindringen in das Schutzgehäuse sowie ein Eindringen von Schmutz oder Regenwasser verhindert werden. Damit die Tür auch in der Energieerzeugungsstellung geschlossen werden kann, muss ein Halterahmen vollständig außerhalb des Schutzgehäuses angeordnet sein und lediglich durch beispielsweise im Inneren des Schutzgehäuses befestigte Drehgelenke mit diesem verbunden sein.

Denkbar ist außerdem, dass ein insbesondere aus Moosgummi gebildetes Dichtungselement vorgesehen ist, welches zwischen dem Schutzgehäuse und der Tür angebracht ist.

In einer Ausgestaltung der Erfindung sind mehrere Energieerzeugungselemente in der Energieerzeugungsstellung pultdach- und/oder satteldachförmig angeordnet, wobei Oberseiten von Halterahmenteilen des Halterahmens vorzugsweise einen Dachabschnitt bilden. Die satteldachförmige Anordnung kann symmetrisch oder asymmetrisch ausgebildet sein. Ein von den Halterahmenteilen gebildeter Dachabschnitt ist bei einer satteldachförmigen Anordnung als First ausgebildet. Mit einer satteldachförmigen Anordnung wird unter den Energieerzeugungselementen ein schattiger Stauraum geschaffen, der beispielsweise zur Lagerung von Gütern wie Ersatzteilen nutzbar ist. Mit einer pultdachförmigen Anordnung, bei der die Energieerzeugungselemente außerdem einem Sonnenstand nachgeführt werden können, ist eine besonders effiziente Energieerzeugung möglich.

Die Erfindung wird nachfolgend anhand von Ausführungsbeispielen und der beigefügten, sich auf die Ausführungsbeispiele beziehenden Zeichnungen, näher erläutert. Es zeigen:
- Fig. 1: eine erfindungsgemäße Vorrichtung in einer Schutzstellung,
- Fig. 2: eine erfindungsgemäße Vorrichtung in verschiedenen Zwischenstellungen bis zu verschiedenen Energieerzeugungsstellungen,
- Fig. 3: Details einer erfindungsgemäßen Vorrichtung,
- Fig. 4: weitere Details einer erfindungsgemäßen Vorrichtung,
- Fig. 5: weitere Details einer erfindungsgemäßen Vorrichtung.

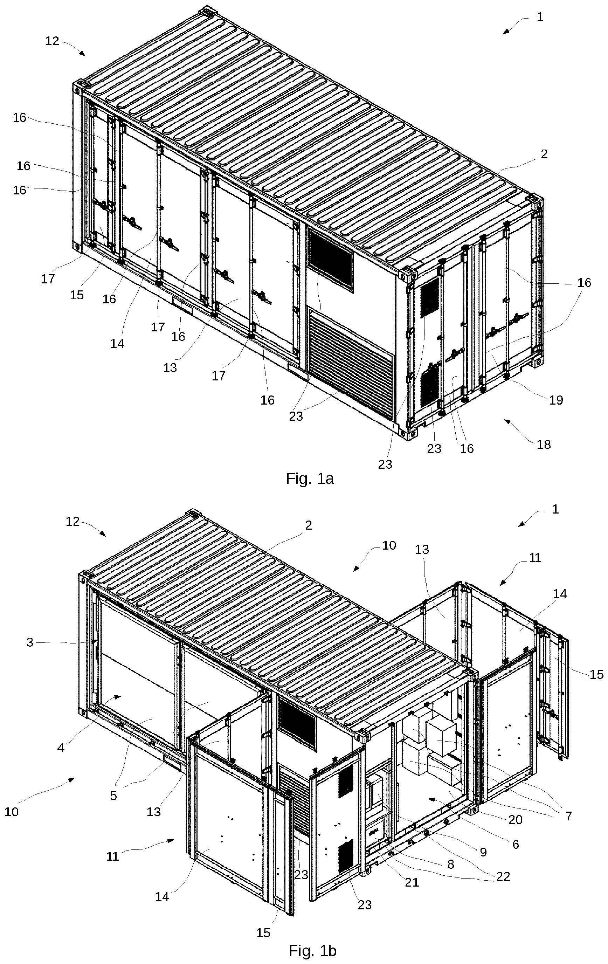

Eine in Fig. 1 in einer perspektivischen Ansicht gezeigte Vorrichtung (1) zur Energieerzeugung ist als Solaranlage zur Stromerzeugung ausgebildet und umfasst einen 20-Fuß-Container (2), dessen Innenraum aufgeteilt ist in einen Aufnahmeraum (3) für in Fig. 1b in einer Draufsicht auf eine Unterseite (4) gezeigte zweiteilige Solarmodule (5) und einen Technikraum (6), in dem Wechselrichter (7), ein Klimagerät (8) sowie Batterien als Stromspeicher (9) untergebracht sind. An beiden Längsseiten (10) des Containers (2) ist ein Seitenwandabschnitt als dreiflügelige Tür (11) ausgebildet, die sich von einer ersten Stirnseite (12) bis zu einer in Fig. 1 nicht gezeigten Rückwand des Technikraums (6) erstreckt und deren Flügel (13, 14, 15) verschwenkbar miteinander verbunden sind. Zwei Flügel (13, 14) der Tür (11) sind gleich groß, während ein dritter Flügel (15) schmaler als die beiden anderen (13, 14) ausgebildet ist. Jeder Türflügel (13-15) weist mindestens ein Verschlusselement (16) auf, das in einer in Fig. 1a gezeigten Schließstellung der Tür auf einer Ober- und einer Unterseite in Verschlussaufnahmen (17) des Containers (2) eingreift. Die Tür (11) ist in Fig. 1b in einer möglichen Offenstellung gezeigt.

An einer zweiten Stirnseite (18) ist eine zweiflügelige Zugangstür (19) zu dem Technikraum (6) vorgesehen, die durch Verschlusselemente (16) in einer in Fig. 1a gezeigten Schließstellung gehalten werden kann. Die in dem Technikraum untergebrachten Bauteile (7-9) sind an lösbar mit dem Container (2) verbindbaren Traggestellen (20, 21) angebracht, die an einer Unterseite Aufnahmetaschen (22) für Gabeln eines Gabelstaplers aufweisen und die als Module einzeln austauschbar sind. Lüftungsschlitze (23) in dem Container ermöglichen eine Belüftung des Technikraums (6). Die Zugangstür (19) ist in Fig. 1b in einer Offenstellung und in Fig. 1a in einer Schließstellung gezeigt.

Eine in Fig. 1a und b gezeigte Stellung der Solarmodule (5) ist die Schutzstellung, in der die Solarmodule (5) in dem Container (2) angeordnet und vor äußeren Einflüssen wie Stößen oder Witterungseinflüssen geschützt sind. Vorzugsweise ist der Container (2) in der Schutzstellung durch die mehrflügelige Tür (11) wie in Fig. 1a gezeigt verschlossen.

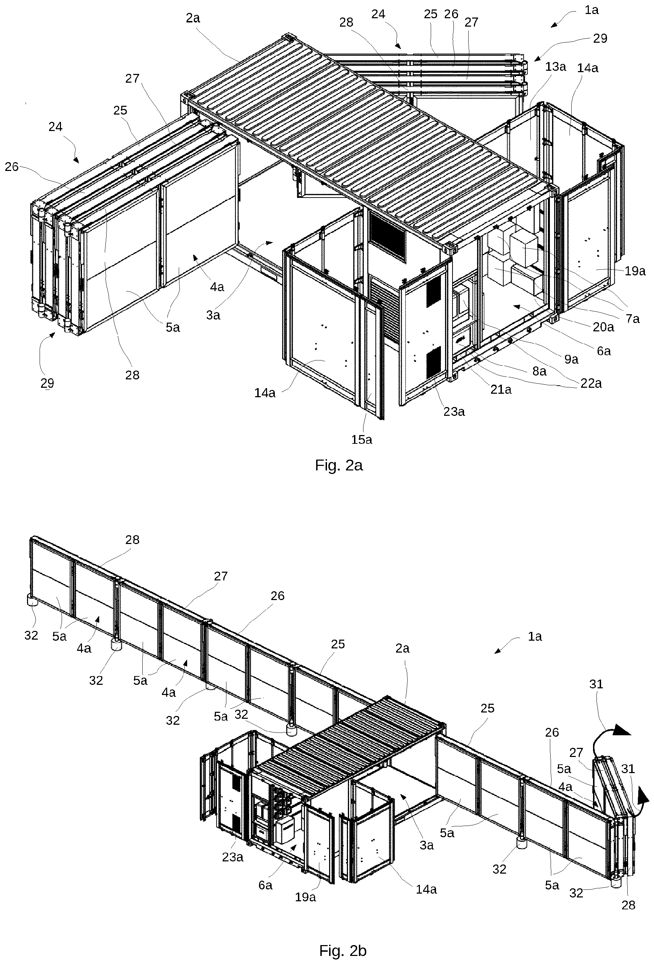

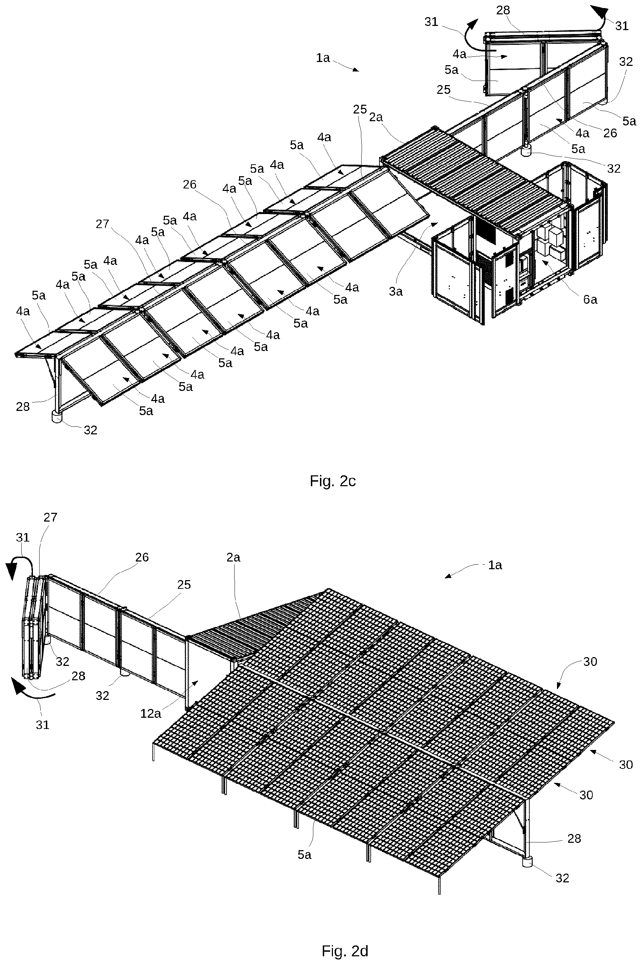

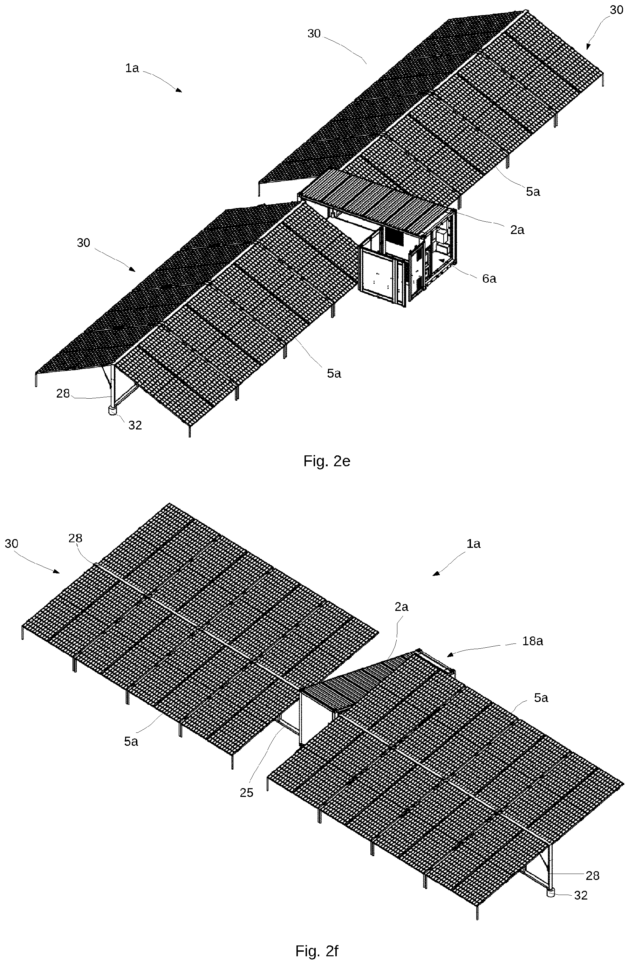

Es wird nun auf Fig. 2 Bezug genommen, wo gleiche oder gleichwirkende Teile mit derselben Bezugszahl wie in Fig. 1 bezeichnet sind und der betreffenden Bezugszahl jeweils der Buchstabe a beigefügt ist.

Bei in Fig. 2a und b in einer perspektivischen Ansicht gezeigten Vorrichtung (1a) sind drei einen Seitenwandabschnitt eines Containers (2a) bildende Türflügel (13a-15a) geöffnet. Zwei mehrteilige Halterahmen (24), deren rahmenartige Halterahmenteile (25-28) in der in Fig. 2a gezeigten zusammengeklappten Stellung einen Stoß (29) bilden und in die Solarmodule (5a) eingebracht sind, sind aus dem Container (2a) herausgeschwenkt. Auf gegenüberliegenden Seiten eines jeden Halterahmenteils (25-28) sind jeweils zwei zweiteilige Solarmodule (5a) angebracht, die nebeneinander angeordnet sind und deren beide Solarmodulteile mit in Fig. 2d-f gezeigten Energieerzeugungsseiten (30) einander zugewandt zusammengeklappt sind. Vorteilhaft kann durch diese Anordnung eine Beschädigung der Energieerzeugungsseiten (30) vermieden werden. In Fig. 2a, b ist eine Draufsicht auf Unterseiten (4a) der Solarmodule (5a) gezeigt.

Die einzelnen Halterahmenteile (25-28) sind verschwenkbar miteinander verbunden und können aus einer in Fig. 2a gezeigten Stellung in eine in Fig. 2b-d gezeigte Stellung unter Auflösung des Stoßes (29) in Richtung von Pfeilen (31) verschwenkt werden. Zum Abstützen gegen einen Untergrund, auf dem der Container (2a) steht, sind in ihrer Länge veränderbare Abstützelemente (32) vorgesehen, die zwischen benachbarten Halterahmenteilen (25-28) angebracht sind.

Durch Aufklappen der in den Halterahmen (25-28) angeordneten zweiteiligen Solarmodule (5a) in in Fig. 2d-f gezeigte, mögliche Energieerzeugungsstellungen sind Energieerzeugungsseiten (30) der Module (5a) der in Fig. 2 nicht gezeigten Sonne oder zumindest dem Himmel zugewandt.

Eine Anordnung der Solarmodule (5a) in einer der Energieerzeugungsstellungen kann satteldachförmig (Fig. 2e) oder pultdachförmig (Fig. 2f) sein. Bei einer satteldachförmigen Anordnung bilden Oberseiten der Halterahmenteile (25-28) einen First.

Obwohl in Fig. 2e,f sämtliche Solarmodule (5a) in der Energieerzeugungsstellung sind, ist dies nicht unbedingt erforderlich. Eine Anzahl von Solarmodulen (5a) in einer der Energieerzeugungsstellungen ist von einer benötigten Leistung der Vorrichtung (1a) abhängig.

Obwohl in diesem Ausführungsbeispiel zwei gleiche mehrteilige Halterahmen (24) vorgesehen sind, ist denkbar, dass nur ein einziger Halterahmen vorgesehen ist oder dass die beiden Halterahmen (24) verschieden sind, beispielsweise eine unterschiedliche Anzahl von Halterahmenteilen (25-28) aufweisen, die außerdem unterschiedlich groß sein können.

Ferner kann ein in Fig. 1 und 2 nicht gezeigtes Fixierelement vorgesehen sein, das eine ungewollte Bewegung des Halterahmens (24) aus der Schutzstellung heraus verhindert und mit dem Container (2a) fest verbunden ist, beispielsweise mit einer Seitenwand oder einer Containerdecke. Dazu kann ein Fixierabschnitt des Fixierelementes einen Halterahmenabschnitt hintergreifen und durch Betätigung eines Fixierelementhebels aus einer Fixierstellung in eine Freigabestellung bewegt werden. Eine Fixierung des Halterahmens (24) ist insbesondere beim Transport des Containers (2a) per Schiff oder Lastkraftwagen sowie einem Verladen mit einem Kran vorteilhaft.

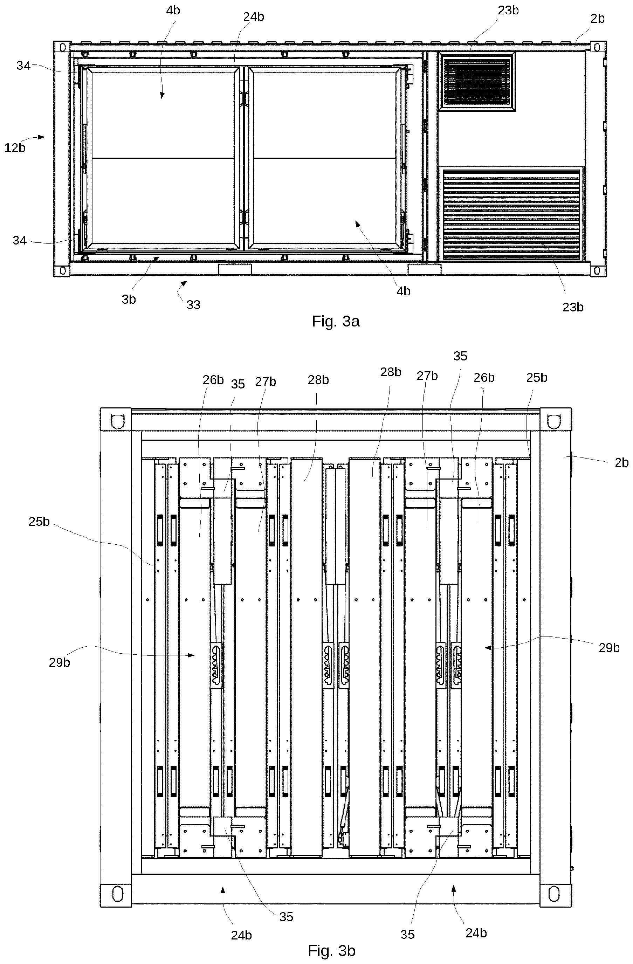

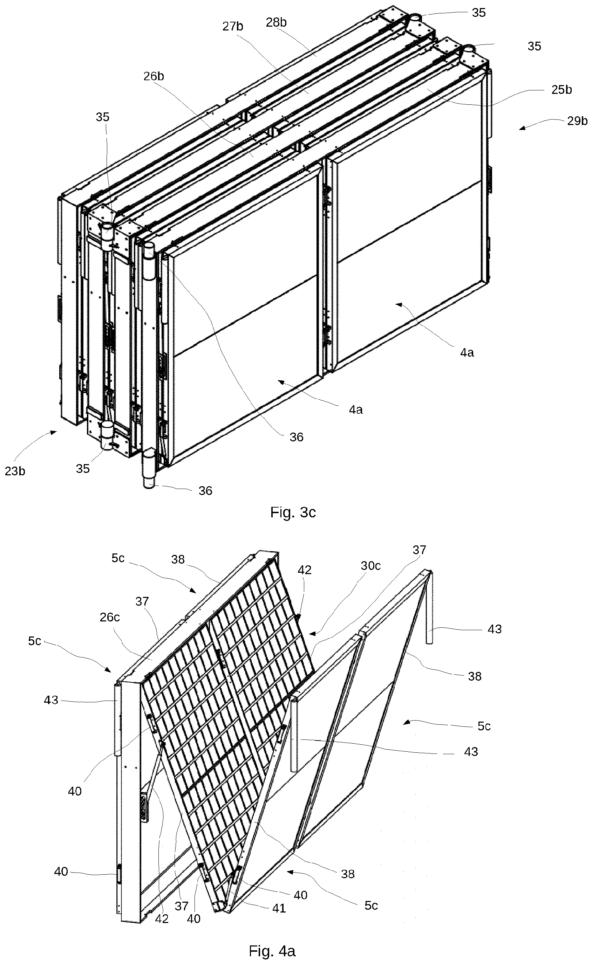

Es wird nun auf Fig. 3 Bezug genommen, wo gleiche oder gleichwirkende Teile mit derselben Bezugszahl wie in Fig. 1 und 2 bezeichnet sind und der betreffenden Bezugszahl jeweils der Buchstabe b beigefügt ist.

Bein einem in Fig. 3a in einer Seitenansicht gezeigten Container (2b) sind zwei mehrteilige Halterahmen (24b) in einer Schutzstellung der Solarmodule (5b) angeordnet. Durch eine Öffnung (33) in jeder Seitenwand sind die Halterahmen (24b) aus der Schutzstellung aus dem Container (2b) heraus verschwenkbar. Die Öffnung (33) kann durch eine in Fig. 1 gezeigte und in Fig. 3 nicht gezeigte Tür verschlossen werden. Jeder Halterahmen (24b) ist mit dem Container (2b) durch zwei Drehgelenke (34) verschwenkbar verbunden.

Die Halterahmen (24b) weisen mehrere in Fig. 3b in einer freigeschnittenen Draufsicht auf eine erste Stirnseite gezeigte, einen Stoß (29b) bildende Halterahmenteile (25b-28b) auf, die einen Aufnahmeraum (3b) des Containers (2b) nahezu vollständig ausfüllen. Benachbarte Halterahmenteile (25b-28b) sind durch Drehgelenke (35), die an einer oberen und einer unteren Seite des Halterahmenteils (25b-28b) angebracht sind, verschwenkbar miteinander verbunden.

Bei einem in Fig. 3c in einer perspektivischen Ansicht im Detail gezeigten Stoß (29b) sind außerdem Zapfen (36) eines Drehgelenks (34) gezeigt, die an dem Halterahmenteil (25b) angebracht sind und die dazu eingerichtet sind, in eine in dem Container (2b) angebrachte, in Fig. 3 nicht gezeigte Aufnahmeeinrichtung zur Ausbildung des Drehgelenks (34) einzugreifen.

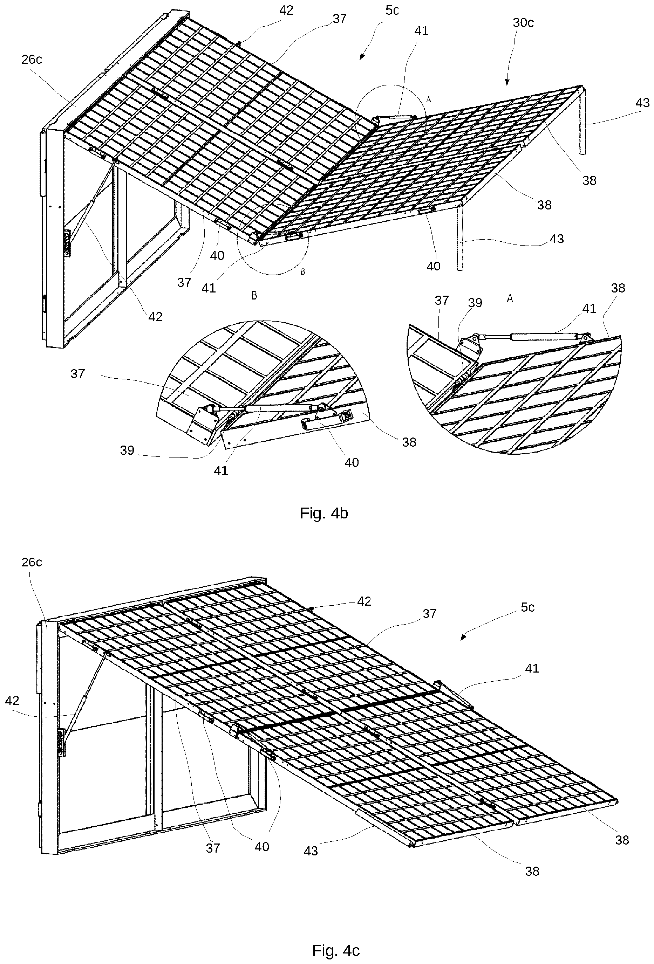

Es wird nun auf Fig. 4 Bezug genommen, wo gleiche oder gleichwirkende Teile mit derselben Bezugszahl wie in Fig. 1 bis 3 bezeichnet sind und der betreffenden Bezugszahl jeweils der Buchstabe c beigefügt ist.

An einem in Fig. 4a in einer perspektivischen Ansicht beispielhaft gezeigten rahmenartigen Halterahmenteil (26c) eines Halterahmens sind auf zwei gegenüberliegenden Seiten jeweils zwei Solarmodule (5c) nebeneinander angeordnet. Jedes der Solarmodule (5c) ist zweiteilig ausgebildet, wobei ein erster Solarmodulteil (37) an einer Oberseite mit dem Halterahmenteil (26c) durch Scharniere verschwenkbar verbunden ist und ein zweiter Solarmodulteil (38) mit dem ersten Teil (37) durch in Fig. 4b in einer Detailansicht A und B gezeigte Scharniere (39). In einer Schutzstellung bilden die beiden Solarmodulteile (37, 38) einen Stoß und sind in dem Halterahmenteil (26c), in dem Energieerzeugungsseiten (30c) aneinander anliegen, angeordnet. Diese Stellung, in der ein Stoß gebildet ist, ist in jeder der Fig. 1 bis 3, in denen eine Draufsicht auf eine Unterseite (4-4b) der Solarmodule (5-5b) gezeigt wird, erkennbar. Alle in dem Halterahmenteil (26c) angeordneten Solarmodule (5c) sind über eine in Fig. 4b gezeigte Zwischenstellung in eine in Fig. 4c gezeigte Energieerzeugungsstellung ausklappbar.

Zur gemeinsamen Bewegung benachbarter Solarmodule (5c) in die in Fig. 4c gezeigte Energieerzeugungsstellung kann ein Bediener an Griffstücken (40) angreifen und die Solarmodulteile (38) in Richtung eines Untergrundes, auf dem ein Container steht, verschwenken. Durch Gasdruckfedern (41, 42) wird ein erforderlicher Kraftaufwand für den Bediener reduziert. Zwei Gasdruckfeder (41) sind zur Unterstützung einer Verschwenkbewegung des ersten (37) zu dem zweiten Solarmodulteil (38) vorgesehen und mit den beiden Solarmodulteilen (37, 38) verbunden. Zwei weitere Gasdruckfedern (42) verbinden das erste Solarmodulteil (37) mit dem Halterahmenteil (26c). Außerdem sind Standfüße (43) vorgesehen, die in der Energieerzeugungsstellung gegen den Untergrund anliegen und ausklappbar sind.

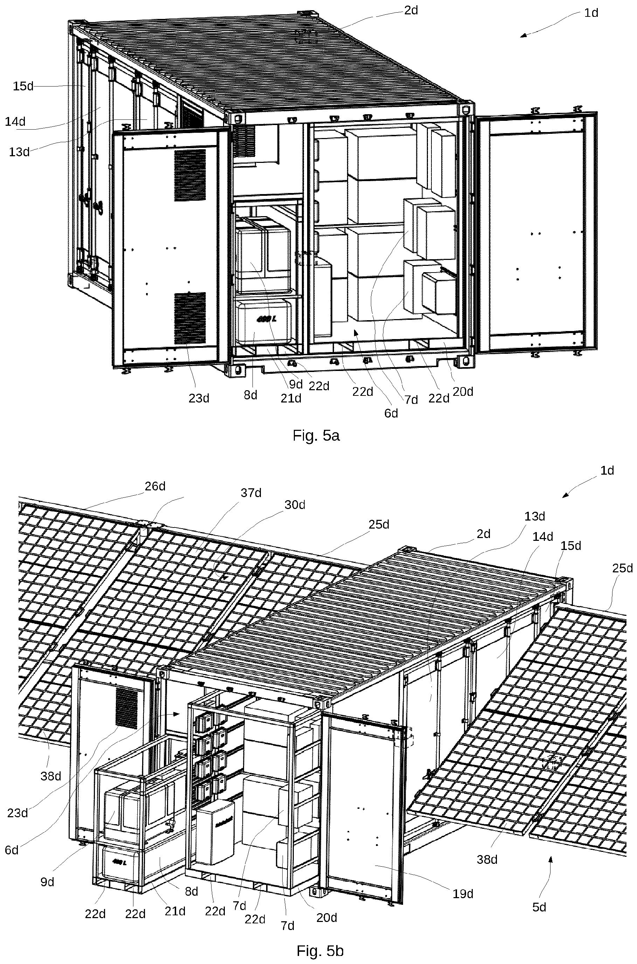

Es wird nun auf Fig. 5 Bezug genommen, wo gleiche oder gleichwirkende Teile mit derselben Bezugszahl wie in Fig. 1 bis 4 bezeichnet sind und der betreffenden Bezugszahl jeweils der Buchstabe d beigefügt ist.

Eine in Fig. 5a in einer perspektivischen Ansicht gezeigte Vorrichtung zur Energieerzeugung (1d) umfasst einen Container (2d), der einen Technikraum (6d) aufweist, in den Wechselrichter (7d) an ein erstes in den Container (2d) einschieb- und herausnehmbares Traggestell (20d) angebracht sind. Außerdem ist ein zweites Traggestell (21d) vorgesehen, an dem eine Batterie (9d) angebracht ist. Die beiden Traggestelle (20d, 21d) erstrecken sich über die gesamte Höhe des Containers (2d) und weisen außerdem Aufnahmetaschen (22d) für Gabeln eines Gabelstaplers auf. Dadurch ist deren einfache Entnahme, beispielsweise für eine Wartung oder einen Austausch von Bauteilen, möglich.

Obwohl in Fig. 5 nicht gezeigt, können die Traggestelle (20d, 21d) an aus dem Container (2d) herausziehbaren, geführt gelagerten Schienen lösbar angebracht sein. Dadurch ist eine

Wartung der Bauteile (7d-9d) möglich. Denkbar ist, dass außerdem ein Endanschlag vorgesehen ist, damit die Traggestelle (20d, 21d) nicht über eine Wartungsstellung heraus aus dem Container (2d) gezogen werden können.

Obwohl denkbar ist, dass die Traggestelle (20d, 21d) durch eine Rastverbindung lösbar mit dem Container (2b) verbindbar sind, wenn sie eingeschoben sind, ist dies nicht unbedingt erforderlich.

Außerdem ist denkbar, dass an den Traggestellen (20, 21; 20d, 21d) angebrachte Bauteile (7-9; 7d-9d) elektrisch miteinander oder mit den Solarmodulen (5-5d) verbindbar sind. Dazu kann jedes Traggestell (20, 21; 20d, 21d) mit einem in Fig. 5 nicht gezeigten Stecker versehen sein, der im eingeschobenen Zustand in eine zugehörige Verbindungsbuchse in dem Container (2-2d) eingesteckt ist.

Obwohl denkbar ist, dass ein Türflügel (15; 15a; 15d) einer mehrflügeligen Tür (11) in einer Energieerzeugungsstellung verschwenkt ist und mit einer Außenseite gegen eine Außenseite eines benachbarten Türflügels (14; 14a; 14d) anliegt, ist der Türflügel (15; 15a; 15d) in der Energieerzeugungsstellung vorzugsweise geschlossen. Dazu kann auf einer Stirnseite des Türflügels (15; 15a; 15d), die einer ersten Stirnseite (12; 12b) eines Schutzgehäuses (2-2b; 2d) zugewandt ist, ein elastisches, gummiartiges, insbesondere aus Moosgummi gebildetes Dichtungselement vorgesehen sein, das sowohl in der Schutzstellung als auch in der Energieerzeugungsstellung eine Abdichtung zwischen dem Türflügel (15; 15a; 15d) und dem Schutzgehäuse (2-2b; 2d) bewirkt. Vorteilhaft kann kein Schmutz oder Wasser in das Schutzgehäuse (2-2b; 2d) eindringen.

Damit die Tür (11) verschlossen werden kann, ist ein Halterahmen (24-24b) durch in einem Schutzgehäuse angebrachte Drehgelenke (35) derart verschwenkbar mit dem Schutzgehäuse (2-2b; 2d) verbunden, dass der Halterahmen (24-24b), insbesondere rahmenartige Halterahmenteile (25-28; 25-28b; 26c; 25d, 26d), in einer Energieerzeugungsstellung vollständig außerhalb des Schutzgehäuses angeordnet sind. Dies ist beispielhaft in Fig. 5b gezeigt.

## Patentansprüche

1. Vorrichtung (1-1b; 1d) zur Energieerzeugung, insbesondere Solaranlage, die ein Schutzgehäuse (2-2b; 2d) und eine Einrichtung zum Halten von Energieerzeugungselementen (5-5d) aufweist, die Halteeinrichtung, die einen mehrteiligen Halterahmen (24-24b) umfasst, aus einer Schutzstellung, in der die Energieerzeugungselemente (5-5d) in dem Schutzgehäuse (2-2b; 2d) angeordnet sind, in eine Energieerzeugungsstellung, in der die Energieerzeugungselemente (5-5d) außerhalb des Schutzgehäuses (2-2b; 2d) angeordnet sind, bewegbar ist, **dadurch gekennzeichnet,**
**dass** der Halterahmen (24-24b) zur Bewegung aus der Schutzstellung in die Energieerzeugungsstellung aus dem Schutzgehäuse (2-2b; 2d) heraus um eine vertikale Achse verschwenkbar ist.

2. Vorrichtung nach Anspruch 1,
**dadurch gekennzeichnet,**
**dass** Halterahmenteile (25-28; 25-28b; 26c; 25d, 26d) des mehrteiligen Halterahmens (24-24b) in der Schutzstellung einen Stoß (29; 29b) bilden und insbesondere verschwenkbar miteinander verbunden sind.

3. Vorrichtung nach Anspruch 1 oder 2,
**dadurch gekennzeichnet,**
**dass** zwischen benachbarten Halterahmenteilen (25-28; 25-28b; 26c; 25d, 26d) des Halterahmens (24-24b) der Halteeinrichtung ein in seiner Länge veränderbares Abstützelement (32) vorgesehen ist, das in der Energieerzeugungsstellung gegen einen Untergrund, auf dem das Schutzgehäuse (2-2b; 2d) steht, anliegt.

4. Vorrichtung nach einem der Ansprüche 1 bis 3,
**dadurch gekennzeichnet,**
**dass** ein Halterahmenteil (25-28; 25-28b; 26c; 25d, 26d) des Halterahmens (24- 24b) der Halteeinrichtung mindestens ein mehrteiliges, vorzugsweise zweiteiliges, Energieerzeugungselement (5-5d) aufweist, dessen Energieerzeugungselementteile (37, 38; 37d, 38d) relativ zueinander bewegbar, insbesondere verschwenkbar sind, wobei die beiden Teile (37, 38) vorzugsweise in der Schutzstellung einen Stoß bilden, bei dem Energieerzeugungsseiten (30; 30c; 30d) einander zugewandt sind.

5. Vorrichtung nach einem der Ansprüche 1 bis 4,
**dadurch gekennzeichnet,**
**dass** ein Halterahmenteil (25-28; 25-28b; 26c; 25d, 26d) desHalterahmens (24- 24b) der Halteeinrichtung mindestens ein mehrteiliges, vorzugsweise zweiteiliges, Energieerzeugungselement (5-5d) aufweist, dessen eines Energieerzeugungselementteil (37; 37d) verschwenkbar mit dem Halterahmenteil (25-28; 25-28b; 26c; 25d, 26d) verbunden ist.

6. Vorrichtung nach einem der Ansprüche 1 bis 5,
**dadurch gekennzeichnet,**
**dass** das Schutzgehäuse quaderförmig ausgebildet ist, vorzugsweise als Container (2-2b; 2d), insbesondere als Frachtcontainer, besonders bevorzugt als 20- oder 40-Fuß-Container.

7. Vorrichtung nach einem der Ansprüche 1 bis 6,
**dadurch gekennzeichnet,**
**dass** das Schutzgehäuse (2-2b; 2d) mindestens zwei von außen zugängliche Räume (3, 6; 3a, 6a; 3b) aufweist, von denen ein erster (3; 3a; 3b) zur Aufnahme der Energieerzeugungselemente (5-5d) in der Schutzstellung vorgesehen ist und ein zweiter (6; 6a) zur Aufnahme elektrischer und/oder elektronischer Bauteile (7-9; 7a-9a; 7d-9d) oder Baugruppen eingerichtet ist.

8. Vorrichtung nach Anspruch 7,
**dadurch gekennzeichnet,**
**dass** der zweite Raum (6; 6a) zur Aufnahme mindestens eines Traggestells (20, 21; 20d, 21d) vorgesehen ist, an dem elektrische und/oder elektronische Bauteile (7-9; 7a-9a; 7d-9d) oder Baugruppen angebracht sind und das insbesondere in den Raum (6; 6a) einschiebbar ist.

9. Vorrichtung nach Anspruch 8,
**dadurch gekennzeichnet,**
**dass** das Traggestell (20, 21; 20d, 21d) auf einer aus dem Schutzgehäuse (2-2b; 2d) herausziehbaren Trageinrichtung, die insbesondere Tragschienen umfasst, angeordnet ist, wobei die Tragschienen in einer Wartungsstellung des Traggestells (20, 21; 20d, 21d) gegen einen Endanschlag anliegen.

10. Vorrichtung nach Anspruch 7 oder 9,
**dadurch gekennzeichnet,**
**dass** das Traggestell (20, 21; 20d, 21d) auf einer dem Schutzgehäuse (2-2b; 2d) zugewandten Seite mit einem elektrischen Verbindungsstecker versehen ist, der im eingeschobenen Zustand zum lösbaren Eingriff in eine in dem Schutzgehäuse (2-2b; 2d) angebrachte Verbindungsbuchse eingerichtet ist.

11. Vorrichtung nach einem der Ansprüche 7 bis 10,
**dadurch gekennzeichnet,**
**dass** einer weiterer, von außen zugänglicher Raum vorgesehen ist, der zur Aufnahme eines batteriebetriebenen Erzeugnisses, insbesondere eines elektrisch angetriebenen Fahrzeugs, während eines Batterieladevorgangs eingerichtet ist.

12. Vorrichtung nach einem der Ansprüche 1 bis 11,
**dadurch gekennzeichnet,**
**dass** ein Schutzgehäuseseitenwandabschnitt als vorzugsweise mehrflügelige Tür (11) ausgebildet ist, die sich von einer ersten Stirnseite (12; 12b) des Schutzgehäuses (2-2b; 2d) bis zu einem zweiten Aufnahmeraum (6; 6a) erstreckt.

13. Vorrichtung nach einem der Ansprüche 1 bis 12,
**dadurch gekennzeichnet,**
**dass** ein Schutzgehäuseseitenwandabschnitt als vorzugsweise mehrflügelige Tür (11) ausgebildet ist, die in der Schutzstellung und in der Energieerzeugungsstellung verschließbar ist.

14. Vorrichtung nach einem der Ansprüche 1 bis 13,
**dadurch gekennzeichnet,**
**dass** mehrere Energieerzeugungselemente (5-5d) in der Energieerzeugungsstellung pultdach- und/oder satteldachfömig angeordnet sind, wobei Oberseiten von Halterahmenteilen (25-28; 25-28b; 26c; 25d, 26d) des Halterahmens (24-24d) vorzugsweise einen Dachabschnitt bilden.

## Claims

1. Apparatus (1-1b; 1d) for generating energy, in particular solar installation, which has a protective housing (2-2b; 2d) and a device for holding energy generation elements (5-5d), the holding device comprising a multi-part holding frame (24-24b) which is movable from a protective position in which the energy generation elements (5-5d) are arranged inside the protective housing (2-2b; 2d) to an energy generation position in which the power generation elements (5- 5d) are arranged outside the protective housing (2-2b; 2d),
**characterized in that** the holding frame (24-24b) can be pivoted out of the protective housing (2-2b; 2d) about a vertical axis for movement from the protective position to the energy generation position.

2. An apparatus according to claim 1,
**characterized in that**
holding frame parts (25-28; 25-28b; 26c; 25d, 26d) of the multipart holding frame (24-24b) form a stack (29; 29b) in the protective position and are connected to one another, in particular pivotably.

3. An apparatus according to claim 1 or 2,
**characterized in that**
between adjacent holding frame parts (25-28; 25-28b; 26c; 25d, 26d) of the holding frame (24-24b) of the holding device, a length-variable support element (32) is provided which, in the energy generation position, rests against a subsoil on which the protective housing (2-2b; 2d) stands.

4. An apparatus according to any one of claims 1 to 3,
**characterized in that**
a holding frame part (25-28; 25-28b; 26c; 25d, 26d) of the holding frame (24- 24b) of the holding device has at least a multi-part, preferably two-part, energy generation element (5-5d), the energy generation element parts (37, 38; 37d, 38d) of which are movable, in particular pivotable, relative to one another, the two parts (37, 38) preferably forming a stack in the protective position, in which power generation sides (30; 30c; 30d) face each other.

5. An apparatus according to any one of claims 1 to 4,
**characterized in that**
a holding frame part (25-28; 25-28b; 26c; 25d, 26d) of the holding frame (24- 24b) of the holding device has at least a multi-part, preferably two-part, energy generation element (5-5d), an energy generation element part (37; 37d) of which is pivotably connected to the holding frame part (25- 28; 25-28b; 26c; 25d, 26d).

6. An apparatus according to any one of claims 1 to 5,
**characterized in that**
the protective housing is cuboidal, preferably a container (2-2b; 2d), in particular a freight container, particularly preferably a 20- or 40-foot container.

7. An apparatus according to any one of claims 1 to 6,
**characterized in that**
the protective housing (2-2b; 2d) has at least two externally accessible rooms (3, 6; 3a, 6a; 3b), a first one (3; 3a; 3b) of which is provided for accommodating the energy generation elements (5-5d) in the protective position and a second one (6; 6a) of which is designed for accommodating electrical and/or electronic components (7-9; 7a-9a; 7d-9d) or assemblies.

8. An apparatus according to claim 7,
**characterized in that**
the second room (6; 6a) is provided for accommodating at least one support frame (20, 21; 20d, 21d) to which electrical and/or electronic components (7-9; 7a-9a; 7d-9d) or assemblies are attached and which, in particular, is insertable into the room (6; 6a).

9. An apparatus according to claim 8,
**characterized in that**
the support frame (20, 21; 20d, 21d) is arranged on a support device which can be pulled out of the protective housing (2-2b; 2d) and comprises, in particular, support rails, the support rails rest against an end stop in a maintenance position of the support frame (20, 21; 20d, 21d).

10. An apparatus according to claim 7 or 9,
**characterized in that**
the support frame (20, 21; 20d, 21d) has an an electrical connection plug on a side facing the protective housing (2-2b; 2d), said plug is arranged in the inserted state for releasable engagement with a connecting socket provided in the protective housing (2-2b; 2d).

11. An apparatus according to any one of claims 7 to 10,
**characterized in that**
a further room accessible from the outside is provided which is designed to accommodate a battery-powered product, in particular an electrically driven vehicle, during a battery charging process.

12. An apparatus according to any one of claims 1 to 11,
**characterized in that**
a protective housing side wall portion is designed as a preferably multi-leaf door (11) extending from a first end face (12; 12b) of the protective housing (2- 2b; 2d) to a second receiving room (6; 6a).

13. An apparatus according to any one of claims 1 to 12,
**characterized in that**
a protective housing side wall section is designed as a preferably multi-leaf door (11) which can be closed in the protective position and in the energy generation position.

14. An apparatus according to any one of claims 1 to 13,
**characterized in that**
a plurality of energy generation elements (5-5d) in the energy generation position are arranged in the shape of a pent roof and/or a gable roof, wherein upper sides of holding frame parts (25-28; 25-28b; 26c; 25d, 26d) of the holding frame (24-24d) preferably form a roof section.

## Revendications

1. Appareil (1-1b; 1d) pour la génération d'énergie, en particulier installation solaire, qui comporte un boîtier de protection (2-2b ; 2d) et un dispositif de maintien des éléments de génération d'énergie (5-5d) comprenant un cadre de maintien en plusieurs parties (24-24b) qui est mobile d'une position de protection dans laquelle les éléments de génération d'énergie (5-5d) sont disposés dans le boîtier de protection (2-2b; 2d) à une position de génération d'énergie dans laquelle les éléments de génération d'énergie (5- 5d) sont à l'extérieur du boîtier de protection (2-2b ; 2d),
**caractérisé en ce que** le cadre de maintien (24-24b) peut pivoter hors du boîtier de protection (2-2b ; 2d) autour d'un axe vertical pour passer de la position de protection à la position de génération d'énergie.

2. Appareil selon la revendication 1,
**caractérisé en ce que** parties (25-28 ; 25-28b ; 26c ; 25d, 26d) du cadre de maintien en plusieurs parties (24-24b) forment une pile (29 ; 29b) en position de protection et sont reliées autre, en particulier de manière pivotante.

3. Dispositif selon la revendication 1 ou 2,
**caractérisé en ce que** qu e un élément de support (32) est prévu entre des parties adjacentes (25-28 ; 25-28b ; 6c ; 25d, 26d) du cadre de maintien (24-24b) du dispositif de maintien, dont la longueur peut être modifiée et qui, dans la position de génératon d'énergie, repose contre un support sur lequel repose le boîtier de protection (2-2b ; 2d).

4. Appareil selon l'une des revendications 1 à 3,
**caractérisé en ce que** une partie (25-28 ; 25-28b ; 26c ; 25d, 26d) du cadre de maintien (24-24b) du dispositif de maintien comporte au moins un élément de génératin d'énergie en plusieurs parties, de préférence en deux parties (5-5d), les parties de l'élément de génération d'énergie (37, 38 ; 37d, 38d) sont mobiles, en particulier pivotante, l'une par rapport à l'autre, les deux parties (37, 38) formant de préférence une pile en position de protection, dans laquelle position les côtés de génération d'énergie (30 ; 30c ; 30d) se font face.

5. Appareil selon l'une des revendications 1 à 4,
**caractérisé en ce qu'**une partie (25-28 ; 25-28b ; 26c ; 25d, 26d) du cadre de maintien (24-24b) du dispositif de maintien comprend au moins un élément de génération d'énergie (5-5d) en plusieurs parties, de préférence en deux parties, dont une partie d'élément de génération d'énergie (37 ; 37d) est reliée de manière pivotante à la partie du cadre de maintien (25- 28 ; 25-28b ; 26c ; 25d, 26d).

6. Appareil selon l'une des revendications 1 à 5,
**caractérisé en ce que** le boîtier de protection est de forme parallélépipédique, de préférence sous forme de conteneur (2-2b ; 2d), en particulier de conteneur de fret, particulièrement avantagé de conteneur de 20 ou 40 pieds.

7. Appareil selon l'une des revendications 1 à 6,
**caractérisé en ce que** le boîtier de protection (2-2b ; 2d) comporte au moins deux espaces accessibles de l'extérieur (3, 6 ; 3a, 6a ; 3b), dont un premier (3 ; 3a ; 3b) est conçu pour recevoir le des éléments de génération d'énergie (5-5d) en position de protection et un second (6 ; 6a) dont une partie est conçue pour recevoir des composants ou des ensembles électriques et/ou électroniques (7-9 ; 7d-9d).

8. Appareil selon la revendication 7,
**caractérisé en ce que** le deuxième espace (6 ; 6a) est conçu pour recevoir au moins un cadre de support (20, 21 ; 20d, 21d) sur lequel des composants ou des ensembles électriques et/ou électroniques (7-9 ; 7a-9a ;7d) sont montés et qui, en particulier, peut être inséré dans l'espace (6 ; 6a).

9. Appareil selon la revendication 8,
**caractérisé en ce que** le cadre de support (20, 21 ; 20d, 21d) est disposé sur un dispositif de support qui peut être sorti du boîtier de protection (2-2b ; 2d) et qui comprend notamment des rails de guidage, les rails de guidage reposant contre une butée dans une position de maintenance du cadre de support (20, 21 ; 20d, 21d).

10. Appareil selon la revendication 7 ou 9,
**caractérisé en ce que** le cadre de support (20, 21 ; 20d, 21d) est pourvu, sur un côté tourné vers le boîtier de protection (2-2b ; 2d), d'une fiche de connexion électrique, ladite fiche à l'état inséré est conçue pour s'engager de manière amovible dans une douille de connexion placée dans le boîtier de protection (2-2b ; 2d).

11. Appareil selon l'une des revendications 7 à 10,
**caractérisé en ce que** un autre espace accessible de l'extérieur est conçu, qui est conçu pour recevoir un produit alimenté par batterie, en particulier un véhicule à propulsion électrique, pendant le processus de chargement de la batterie.

12. Appareil selon l'une des revendications 1 à 11,
**caractérisé en ce que** une partie de la paroi latérale du boîtier de protection est conçue comme une porte de préférence à plusieurs battants (11), ladite porte s'étendant d'une première face d'extrémité (12 ; 12b) du boîtier de protection (2- 2b ; 2d) à un deuxième espace de réception (6 ; 6a).

13. Appareil selon l'une des revendications 1 à 12,
**caractérisé en ce que** une partie de la paroi latérale du boîtier de protection est conçue comme une porte de préférence à plusieurs battants (11) qui peut être fermée en position de protection et position de génération d'énergie.

14. Appareil selon l'une des revendications 1 à 13,
**caractérisé en ce que** plusieurs éléments de génération d'énergie (5-5d) dans la position de génération d'énergie sont disposés sous la forme d'un toit en pente et/ou d'un toit à pignon, dans lequel les côtés supérieurs de parties (25-28 ; 25-28b ; 26c ; 25d, 26d) du cadre de maintien (24-24d) forment de préférence une section de toit.
